# EUROPEAN PATENT APPLICATION

(11) **EP 4 752 678 A1**
(43) Date of publication of application: **03.06.2026**
(21) Application number: 25218575.6
(22) Date of filing: 26.11.2025
(51) Int. Cl.: G06F 1/16, G02F 1/1333, G06F 1/20, H05K 1/02, H05K 1/14, H05K 7/20

(54) **DISPLAY DEVICE**

(30) Priority: 29.11.2024 KR 20240175423; 18.06.2025 KR 20250080110
(71) Applicant: LG Electronics Inc., Yeongdeungpo-gu Seoul 07336 (KR)
(72) Inventor: KO, Kwangho, 07796 Seoul (KR); KIM, Chanwoo, 07796 Seoul (KR); YOON, Jihoon, 07796 Seoul (KR)
(74) Representative: Vossius & Partner Patentanwälte Rechtsanwälte mbB

(57) **Abstract**

Disclosed is a display device. The display device includes a display panel configured to display an image, a housing elongated along a lower side of the display panel, and a vertical board assembly provided in the housing and electrically connected to the display panel. The vertical board assembly includes a first vertical board having a surface of which chips are mounted, wherein the surface of the first vertical board is parallel to the display panel, and the housing includes a plurality of vent holes under the first vertical board.

## Description

### CROSS-REFERENCE TO RELATED APPLICATION

This application claims the priority benefit of Korean Patent Application No. 10-2024-0175423, filed on November 29, 2024 and Korean Patent Application No.10-2025-0080110, filed on June 18, 2025 in the Korean Intellectual Property Office, the disclosure of which is incorporated herein by reference.

### BACKGROUND OF THE DISCLOSURE

### Field of the disclosure

The present disclosure relates to a display device. More particularly, the present disclosure relates to a display device including a transparent display panel.

### Description of the Related Art

With the advent of the information society, various demands for display devices are increasing. Various display devices, such as liquid crystal display (LCD) devices, plasma display panel (PDP) devices, electroluminescent display (ELD) devices, vacuum fluorescent display (VFD) devices, and organic light emitting diode (OLED) devices, have recently been studied and used to meet various demands for display devices.

Thereamong, an LCD panel includes a thin-film transistor (TFT) substrate and a color substrate, which are disposed opposite each other with a liquid crystal layer interposed therebetween, and may display an image using light provided from a backlight unit. An OLED panel may display an image by depositing a self-emissive organic layer on a substrate having a transparent electrode formed thereon.

Recently, various studies have been conducted on transparent display panels that not only display images to a user but also allow the user to see through the display panel.

### SUMMARY OF THE DISCLOSURE

An object of the present disclosure may be to solve the above and other problems.

Another object of the present disclosure may be to provide a display device having improved performance.

Still another object of the present disclosure may be to provide a display device having enhanced heat dissipation performance.

Yet another object of the present disclosure may be to provide a heat dissipation structure capable of smoothly dissipating heat.

Still yet another object of the present disclosure may be to provide a display device having improved assemblability.

In accordance with one aspect of the present disclosure for accomplishing the above or other objectives, a display device may include a display panel configured to display an image, a housing elongated along a lower side of the display panel, and a vertical board assembly provided in the housing and electrically connected to the display panel, wherein the vertical board assembly may include a first vertical board having a surface on which chips are mounted, wherein the surface of the first vertical board is parallel to the display panel, and wherein the housing may include a plurality of vent holes under the first vertical board.

### BRIEF DESCRIPTION OF THE DRAWINGS

The above and other objects, features, and other advantages of the present disclosure will be more clearly understood from the following detailed description taken in conjunction with the accompanying drawings, in which:

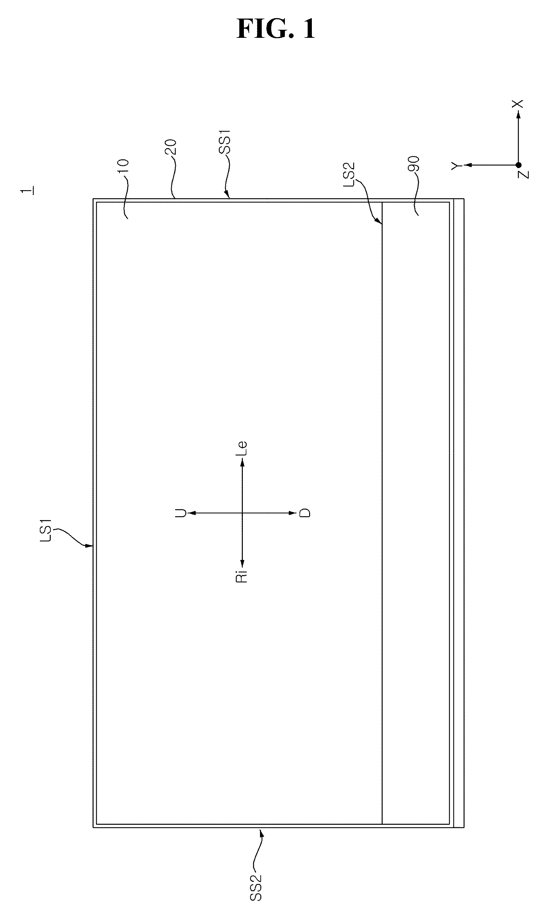

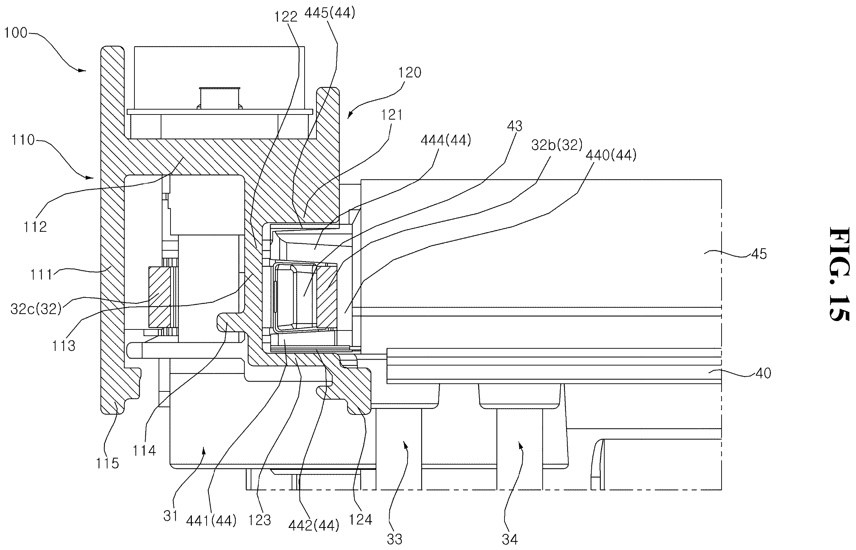

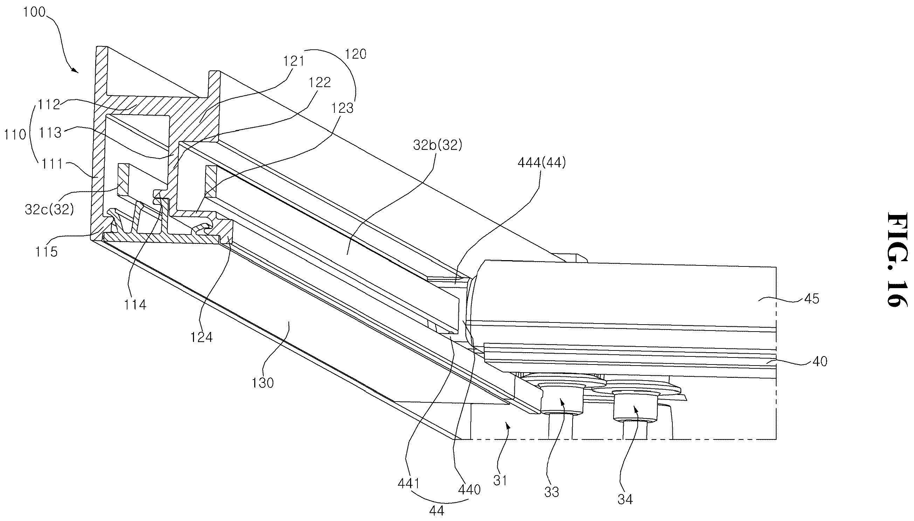

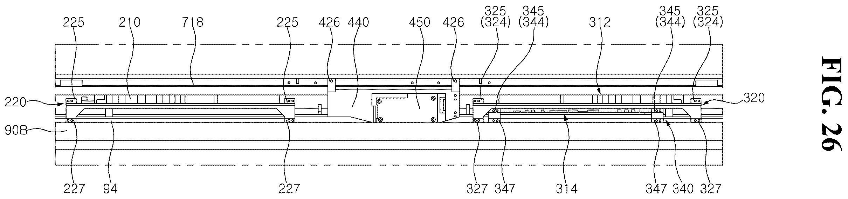

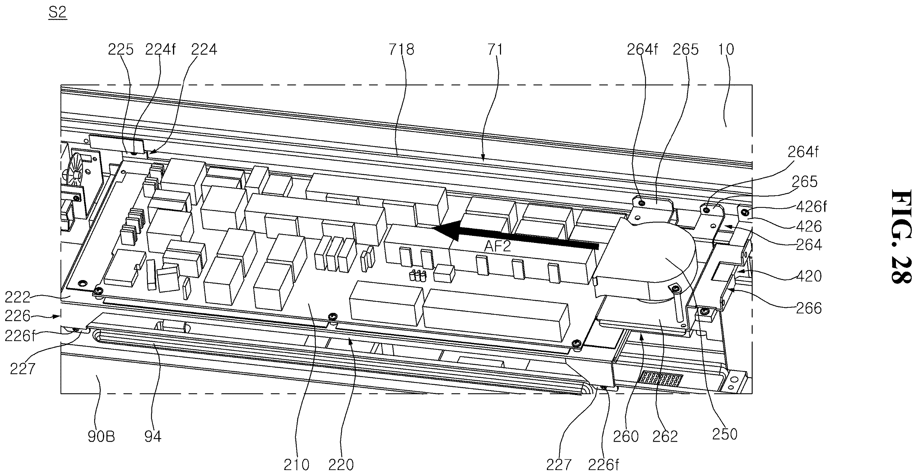

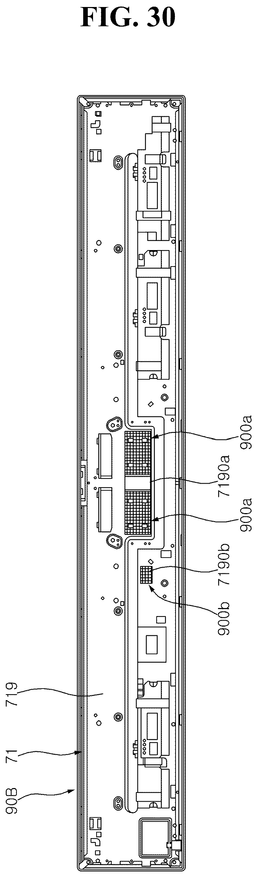

FIGs. 1 to 30 are views showing examples of a display device according to embodiments of the present disclosure.

### DETAILED DESCRIPTION OF THE PREFERRED EMBODIMENTS

Hereinafter, the embodiments disclosed in the present specification will be described in detail with reference to the accompanying drawings, and the same or similar elements are denoted by the same reference numerals even though they are depicted in different drawings, and redundant descriptions thereof will be omitted.

In the following description, with respect to constituent elements used in the following description, the suffixes "module" and "unit" are used only in consideration of facilitation of description, and do not have mutually distinguished meanings or functions.

In the following description of the embodiments disclosed in the present specification, a detailed description of known functions and configurations incorporated herein will be omitted when the same may make the subject matter of the embodiments disclosed in the present specification rather unclear. In addition, the accompanying drawings are provided only for a better understanding of the embodiments disclosed in the present specification and are not intended to limit the technical ideas disclosed in the present specification. Therefore, it should be understood that the accompanying drawings include all modifications, equivalents, and substitutions within the scope and sprit of the present disclosure.

It will be understood that although the terms "first," "second," etc., may be used herein to describe various components, these components should not be limited by these terms. These terms are only used to distinguish one component from another component.

It will be understood that when a component is referred to as being "coupled to," "fixed to," "mounted to," "connected to," or "liked to" another component, intervening components may be present. On the other hand, when a component is referred to as being "directly coupled to," "directly fixed to," "directly mounted to," "directly connected to," or "directly liked to" another component, there are no intervening components present.

As used herein, the singular forms are intended to include the plural forms as well, unless the context clearly indicates otherwise.

It will be further understood that the terms "comprises," "comprising," "includes," and/or "including," when used herein, specify the presence of stated features, integers, steps, operations, elements, components, or combinations thereof, but do not preclude the presence or addition of one or more other features, integers, steps, operations, elements, components, or combinations thereof.

In the embodiments illustrated in the drawings, representations of directions, such as up (U), down (D), left (Le), right (Ri), front (F), and rear (R), are merely for convenience of explanation, and are not intended to limit the technical features disclosed in this specification.

Referring to FIG. 1, a display device 1 may include a display 10, a side frame 20, and a housing 90. The display 10 may display an image. The side frame 20 may extend along a periphery of the display 10. The housing 90 may be located below the display 10 and the side frame 20. Alternatively, the housing 90 may be located above, on the left side of, on the right side of, or below the display 10 and the side frame 20.

The display 10 may include a first long side LS1, a second long side LS2 opposite the first long side LS1, a first short side SS1 adjacent to the first and second long sides LS1 and LS2, and a second short side SS2 opposite the first short side SS1.

For convenience of explanation, the lengths of the first and second long sides LS1 and LS2 are shown and described as being greater than the lengths of the first and second short sides SS1 and SS2. However, the lengths of the first and second long sides LS1 and LS2 may be set to be approximately equal to the lengths of the first and second short sides SS1 and SS2.

A direction parallel to the long sides LS1 and LS2 of the display 10 may be referred to as a leftward-rightward direction. A direction parallel to the short sides SS1 and SS2 of the display 10 may be referred to as an upward-downward direction. A direction perpendicular to the long sides LS1 and LS2 and the short sides SS1 and SS2 of the display 10 may be referred to as a forward-backward direction.

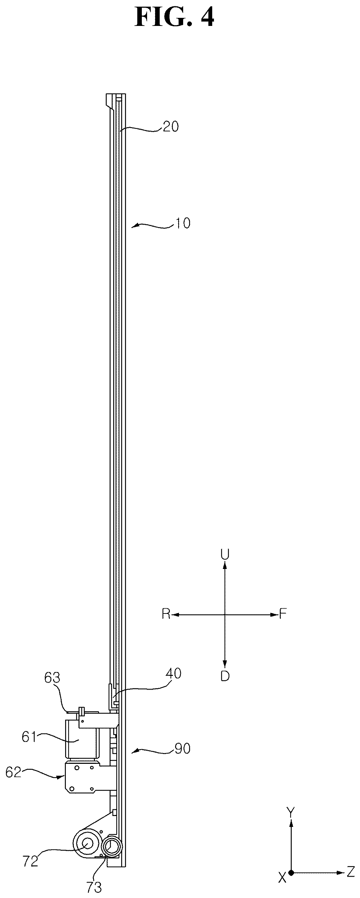

A side of the display 10 on which an image is displayed may be referred to as a front side F or z (see FIG. 4), and a side opposite the front side may be referred to as a rear side R or -z (see FIG. 4). The first short side SS1 may be referred to as a left side Le or x. The second short side SS2 may be referred to as a right side Ri or -x. The first long side LS1 may be referred to as an upper side U or y. The second long side LS2 may be referred to as a lower side D or -y.

Hereinafter, a display panel using an organic light emitting diode (OLED) will be described as an example. However, the display panel applicable to the present disclosure is not limited thereto.

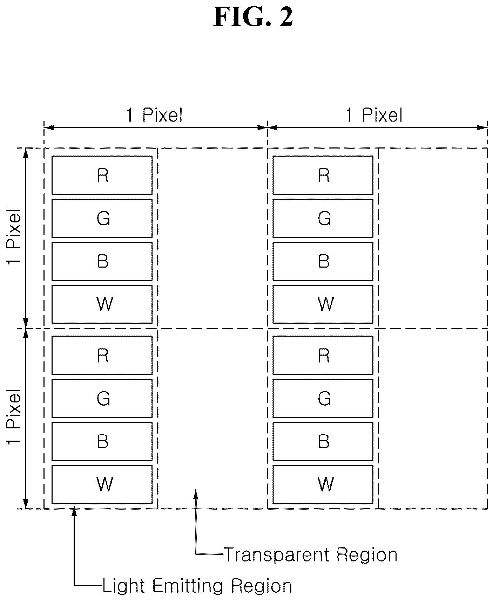

Referring to FIG. 2, a pixel may include a light emitting region and a transparent region. In the light emitting region, subpixels of red, green, blue, and white (RGBW) may be disposed in a vertical direction, and the transparent region having no subpixel may be disposed adjacent to the light emitting region.

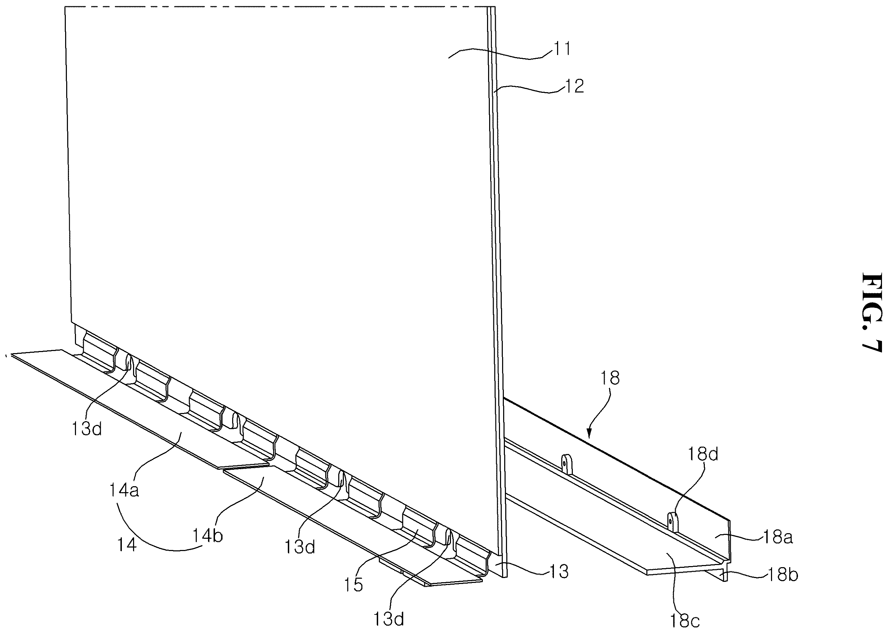

Accordingly, a display panel 11 (see FIG. 7) including a plurality of pixels may not only display an image but also transmit light. The display panel 11 (see FIG. 7) may be referred to as a transparent display panel or a transparent OLED panel.

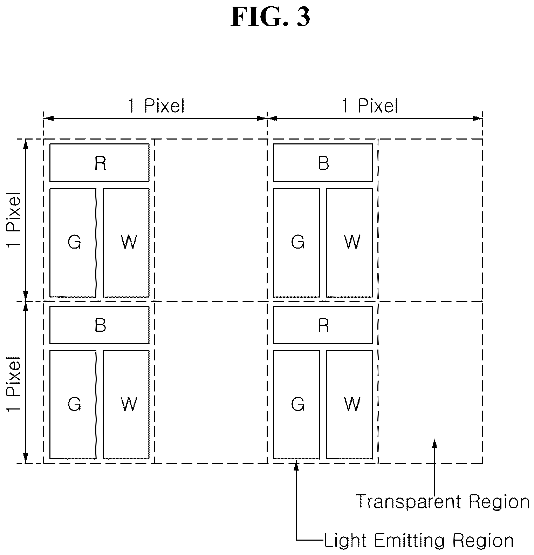

Referring to FIG. 3, a pixel may include a light emitting region and a transparent region. In the light emitting region, subpixels of red, green, and white (RGW) or blue, green, and white (BGW) may be disposed adjacent to each other, and the transparent region having no subpixel may be disposed adjacent to the light emitting region.

Accordingly, a display panel 11 (see FIG. 7) including a plurality of pixels may not only display an image but also transmit light. The display panel 11 (see FIG. 7) may be referred to as a transparent display panel or a transparent OLED panel.

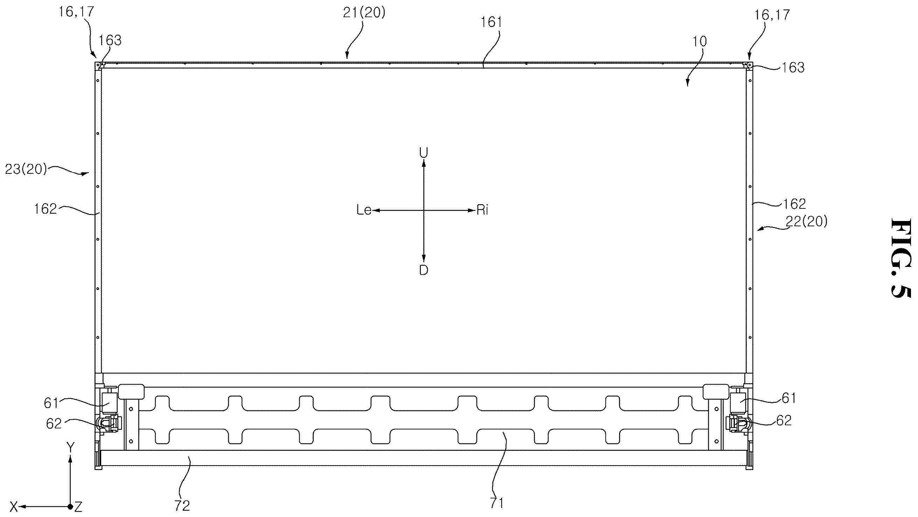

Referring to FIGs. 4 and 5, the display 10 may be coupled to the side frame 20. A housing frame 71 may be coupled or fixed to the side frame 20. The housing frame 71 may cover a rear surface of the display 10. The housing frame 71 may be located at a rear side of the display 10. The housing frame 71 may be referred to as a rear frame 71, a rear plate 71, or a rear base 71. The housing frame 71 may have a length corresponding to the lengths of the long sides LS1 and LS2 (see FIG. 1) of the display 10. The housing frame 71 may have a width that is less than the lengths of the short sides of the display 10.

A plurality of motors 61 may be provided. The plurality of motors 61 may be disposed at a rear side of the display 10 so as to be respectively adjacent to the left and right sides of the display 10. A pair of motors 61 may be provided to supply dual driving power. A plurality of gearboxes 62 may be provided corresponding to the plurality of motors 61. Each of the plurality of gearboxes 62 may be connected to a corresponding one of the plurality of motors 61. A pair of gearboxes 62 may be provided to transmit the dual driving power supplied by the pair of motors 61. The motors 61 and/or the gearboxes 62 may be coupled or fixed to the rear surface of the housing frame 71. The motors 61 and/or the gearboxes 62 may not be exposed toward a front side of the display device 1 by the housing frame 71. A bar 40 may move upward and downward while sliding in the side frame 20.

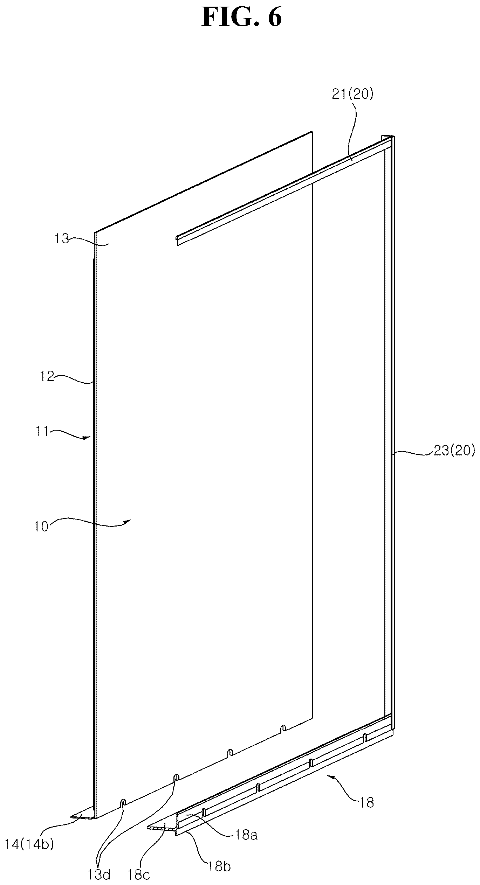

Referring to FIG. 6 together with FIG. 5, the display 10 may be coupled to the side frame 20. A lower frame 18 may be coupled or fixed to the side frame 20 and may support the display 10 at a lower side of the display 10. The side frame 20 may include a first part 21, a second part 22, and a third part 23.

The first part 21 may be coupled to an upper side of the display 10, the second part 22 may be coupled to a right side of the display 10, and the third part 23 may be coupled to a left side of the display 10. The lower frame 18 may be coupled or fixed to the second part 22 and/or the third part 23 of the side frame 20.

Vertical fixing members 162 may be respectively coupled to the second part 22 and the third part 23, and a horizontal fixing member 161 may be coupled to the first part 21. Corner fixing members 16 and pulleys 17 may be coupled to the vertical fixing members 162 and/or to the horizontal fixing member 161 at upper corners.

Referring to FIG. 7 together with FIG. 6, the display panel 11 may divide an image into a plurality of pixels and may output the image by adjusting color, brightness, and saturation for each pixel. The display panel 11 may be divided into an active area (AA) in which an image is displayed and a de-active area (DA) in which an image is not displayed. The display panel 11 may emit light corresponding to a color of red (R), green (G), or blue (B) in response to a control signal.

A source printed circuit board (source PCB) 14 may be adjacent to a lower side of the display panel 11. The source PCB 14 may extend along the lower side of the display panel 11. The source PCB 14 may be electrically connected to the display panel 11 via a chip on film (COF) 15. The source PCB 14 may be electrically connected to a timing controller board (T-CON board) via a cable (not shown) such as a flexible flat cable (FFC).

A transparent panel 13 may be located in front of the display panel 11. The transparent panel 13 may be glass made of a transparent material. An adhesive film 12 may be located between the display panel 11 and the transparent panel 13 and may be coupled to the display panel 11 and the transparent panel 13. The adhesive film 12 may be an optically clear adhesive (OCA) film. The transparent panel 13 may be referred to as a front panel 13.

The adhesive film 12 may cover at least a portion of a rear surface of the transparent panel 13. For example, one side of the adhesive film 12 may be located closer to the center of the display panel 11 than a corresponding side of the transparent panel 13. The adhesive film 12 may have a smaller size or area than the transparent panel 13. For example, upper, left, and right sides of the adhesive film 12 may be adjacent to upper, left, and right sides of the transparent panel 13, respectively, and a lower side of the adhesive film 12 may be spaced upward from a lower side of the transparent panel 13.

The adhesive film 12 may have a size corresponding to the size of the display panel 11. For example, the adhesive film 12 may have a diagonal length that is substantially equal to the diagonal length of the display panel 11. In another example, the diagonal length of the adhesive film 12 may be greater than the diagonal length of the display panel 11. A portion of the adhesive film 12 may be disposed along a periphery of the display panel 11 outside the display panel 11. For example, the adhesive film 12 may form a rectangular line along the periphery of the display panel 11.

An assembly of the display panel 11, the adhesive film 12, and the transparent panel 13 may be referred to as the display 10.

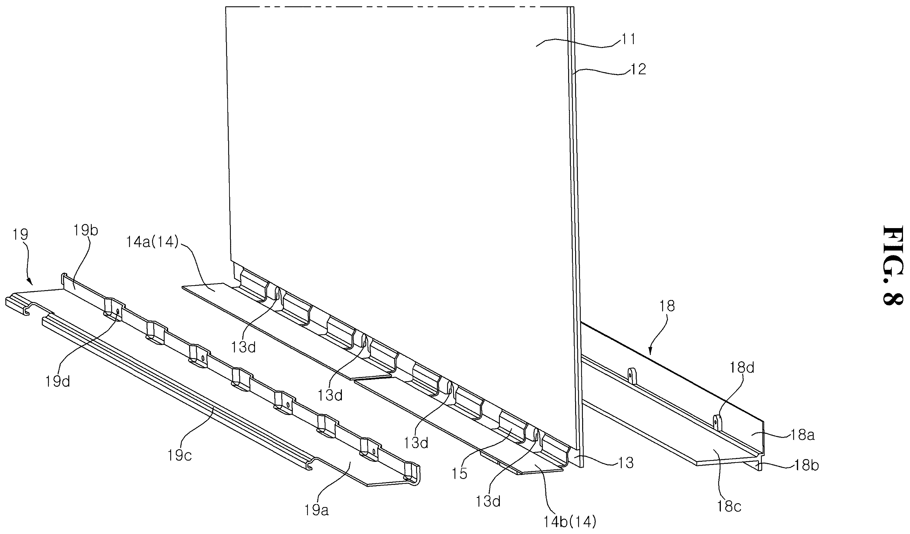

Referring to FIG. 8 together with FIG. 7, the lower frame 18 may include a horizontal portion 18c, a first vertical portion 18a, a second vertical portion 18b, and a coupling portion 18d. The horizontal portion 18c may be an elongated plate, and the first vertical portion 18a may extend upward from a front edge of the horizontal portion 18c while forming a right angle with the horizontal portion 18c. The second vertical portion 18b may extend downward from the front edge of the horizontal portion 18c while forming a right angle with the horizontal portion 18c. The coupling portion 18d may protrude from a rear surface of the first vertical portion 18a. The coupling portion 18d may be formed on an upper surface of the horizontal portion 18c and/or on the rear surface of the first vertical portion 18a. A plurality of coupling portions 18d may be disposed at regular intervals.

The transparent panel 13 may include a coupling recess 13d, which is a portion cut out in a lower side of the transparent panel 13. The coupling recess 13d in the transparent panel 13 may correspond to the coupling portion 18d of the lower frame 18. The coupling portion 18d of the lower frame 18 may be inserted into the coupling recess 13d in the transparent panel 13. The first vertical portion 18a may cover a front surface of the transparent panel 13 adjacent to the lower side of the transparent panel 13. The horizontal portion 18c of the lower frame 18 may support the transparent panel 13.

The source PCB 14 may be located on the horizontal portion 18c of the lower frame 18. The source PCB 14 may face or be in contact with the horizontal portion 18c of the lower frame 18.

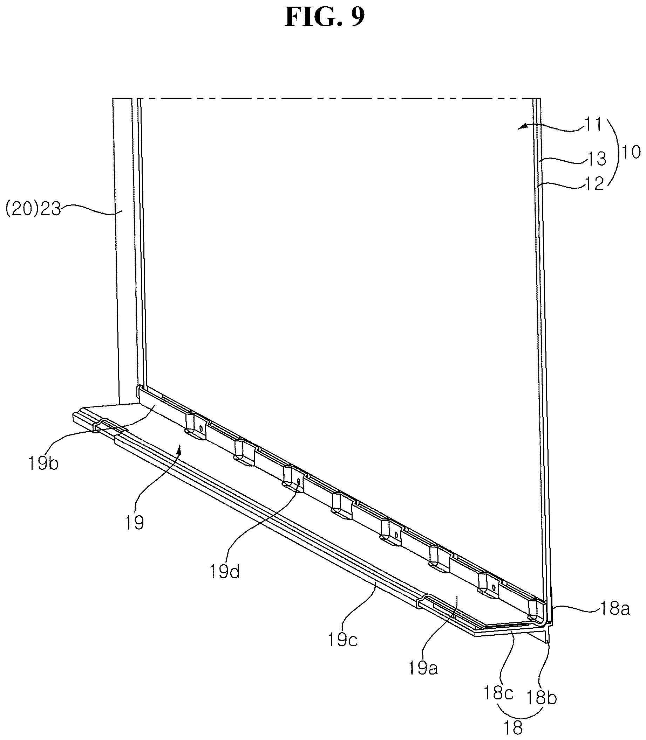

Referring to FIG. 9 together with FIG. 8, a PCB cover 19 may include a horizontal portion 19a, a folded portion 19c, a vertical portion 19b, and a fixing portion 19d. The horizontal portion 19a may be an elongated plate and may cover the source PCB 14. The vertical portion 19b may extend or bend upward from an edge of the horizontal portion 19a. The folded portion 19c may be opposite the vertical portion 19b with respect to the horizontal portion 19a. The folded portion 19c may extend from the horizontal portion 19a while bending toward a lower surface of the horizontal portion 19a. The folded portion 19c may face the horizontal portion 19a. The fixing portion 19d may be formed on the vertical portion 19b. The fixing portion 19d may be formed so as to protrude forward from the vertical portion 19b by pressing a portion of the vertical portion 19b. The fixing portion 19d may be fixed to the coupling portion 18d of the lower frame 18.

When the folded portion 19c of the PCB cover 19 is coupled to the horizontal portion 18c of the lower frame 18 and the fixing portion 19d of the PCB cover 19 is fixed to the coupling portion 18d of the lower frame 18, the PCB cover 19 may cover the source PCB 14.

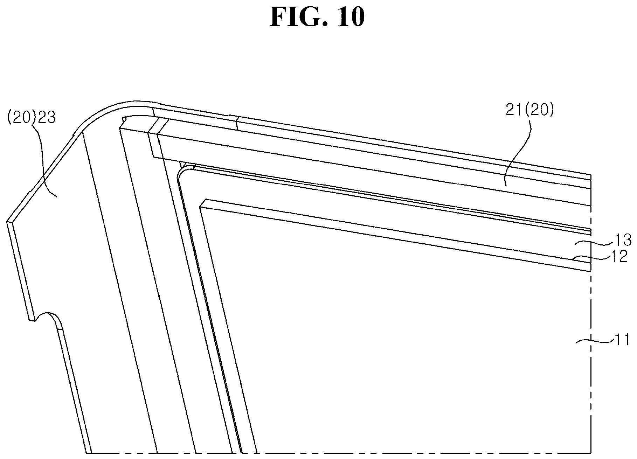

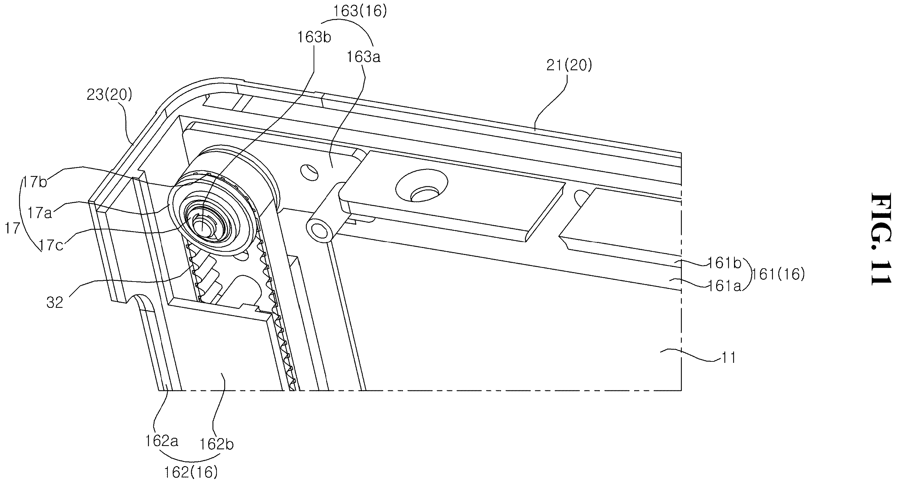

Referring to FIGs. 10 and 11, the display panel 11 may be disposed on a rear surface of the transparent panel 13. The display panel 11 may be attached or fixed to the adhesive film 12.

A frame fixing member 16 may include a horizontal fixing member 161, a vertical fixing member 162, and a corner fixing member 163. The horizontal fixing member 161 may be integrally formed with the vertical fixing member 162. The horizontal fixing member 161 and the vertical fixing member 162 may be referred to as inner frames 161 and 162. The horizontal fixing member 161 may include a plate 161a and a wall 161b. The plate 161a may be elongated in the leftward-rightward direction and may be fixed to the first part 21 of the side frame 20. The wall 161b may be formed on the plate 161a. The wall 161b may protrude backward from an outer surface of the plate 161a.

The vertical fixing member 162 may include a plate 162a and a wall 162b. The plate 162a may be elongated in the upward-downward direction and may be fixed to the third part 23 of the side frame 20. The wall 162b may be formed on the plate 162a. The wall 162b may protrude in the leftward-rightward direction from an outer surface of the plate 162a.

The corner fixing member 163 may be a bent plate segment. The corner fixing member 163 may be a plate 163a bent along a corner between the vertical fixing member 162 and the horizontal fixing member 161. A pulley shaft 163b may protrude and extend from an outer surface of the plate 163a of the corner fixing member 163 toward a rear side of the transparent panel 13. The corner fixing member 163 may be attached or fixed to the horizontal fixing member 161 and/or to the vertical fixing member 162. The corner fixing member 163 may be referred to as a left corner fixing member 163 or a first corner fixing member 163. When the corner fixing member 163 is located at a corner defined by the first part 21 and the second part 22 of the side frame 20 (see FIG. 5), the corner fixing member 163 may be referred to as a right corner fixing member 163 or a second corner fixing member 163.

The pulley 17 may be fitted on the pulley shaft 163b. The pulley 17 may rotate on the pulley shaft 163b. The pulley 17 may be referred to as an upper pulley 17. For example, a lubricant for noise prevention may be applied between the pulley shaft 163b and the pulley 17. In another example, the pulley 17 may be formed of synthetic resin having low frictional resistance, and the pulley shaft 163b may include metal to prevent noise and allow smooth rotation of the pulley 17. A belt 32 may be wound around the pulley 17.

The pulley 17 may include a wheel 17a and a belt gear 17b. The wheel 17a may be formed in a ring or rim shape. The pulley shaft 163b may be inserted into the wheel 17a, and the wheel 17a may rotate on the pulley shaft 163b. The belt gear 17b may define an outer circumferential surface of the wheel 17a. A fixing washer 17c may be coupled to the pulley shaft 163b at a position adjacent to an end of the pulley shaft 163b. For example, the fixing washer 17c may be an E-ring. The fixing washer 17c may prevent separation of the pulley 17 from the pulley shaft 163b. The first pulley 17 or the left pulley 17 may be located on the first corner fixing member 163 or the left corner fixing member 163, and the second pulley 17 (see FIG. 5) or the right pulley 17 (see FIG. 5) may be located on the second corner fixing member 163 or the right corner fixing member 163.

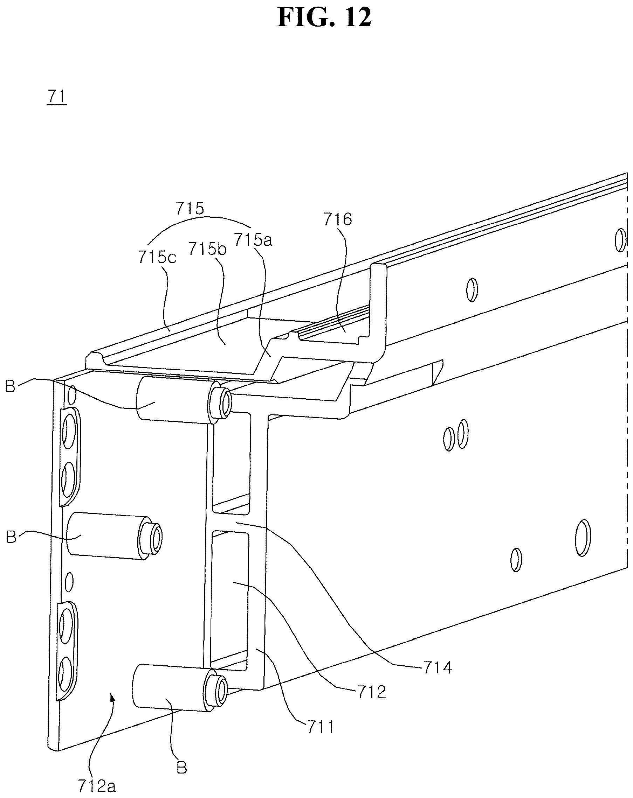

Referring to FIG. 12, the housing frame 71 may include a front part 712, a rear part 711, an inner rib 714, a bar support 715, and a top part 716. The front part 712 may face the rear part 711. The rear part 711 may be opposite the front part 712. The inner rib 714 may be formed between the front part 712 and the rear part 711 to interconnect the front part 712 and the rear part 711. A gap or a space may be defined between the front part 712 and the rear part 711 by the inner rib 714.

The bar support 715 may include a back support 715a, a bottom support 715b, and a front support 715c. For example, the bar support 715 may be generally L-shaped. The front support 715c may be located opposite the back support 715a with respect to the bottom support 715b. The front support 715c and/or the back support 715a may define a wall with respect to the bottom support 715b. The back support 715a may have a greater height than the front support 715c. The top part 716 may be connected to the back support 715a.

A mounting part 712a may be defined by a portion of the front part 712 that is exposed as the rear part 711 is cut out. When the rear part 711 and/or the inner rib 714 is cut out, a rear surface of a portion of the front part 712 may be exposed. Bosses B may be fixed to the mounting part 712a.

Accordingly, torsional and/or bending rigidity of the housing frame 71 may be increased.

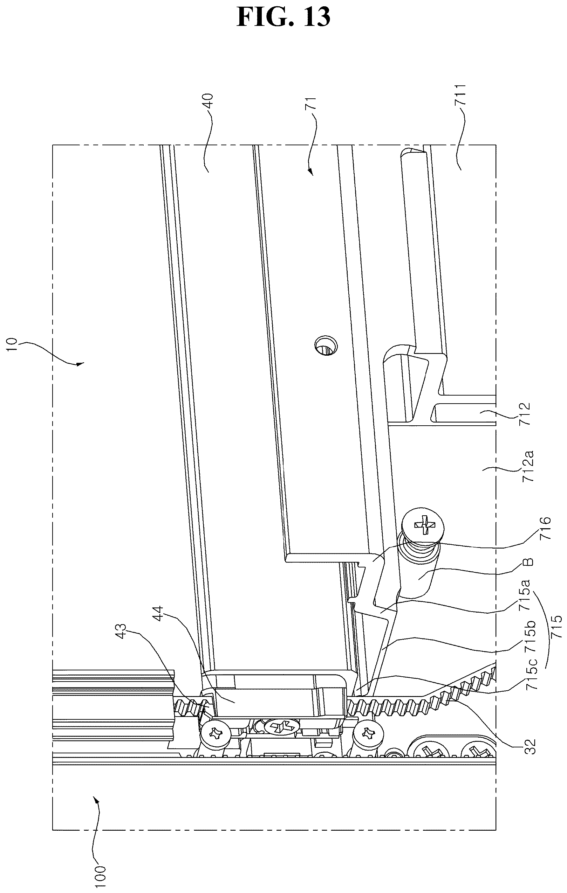

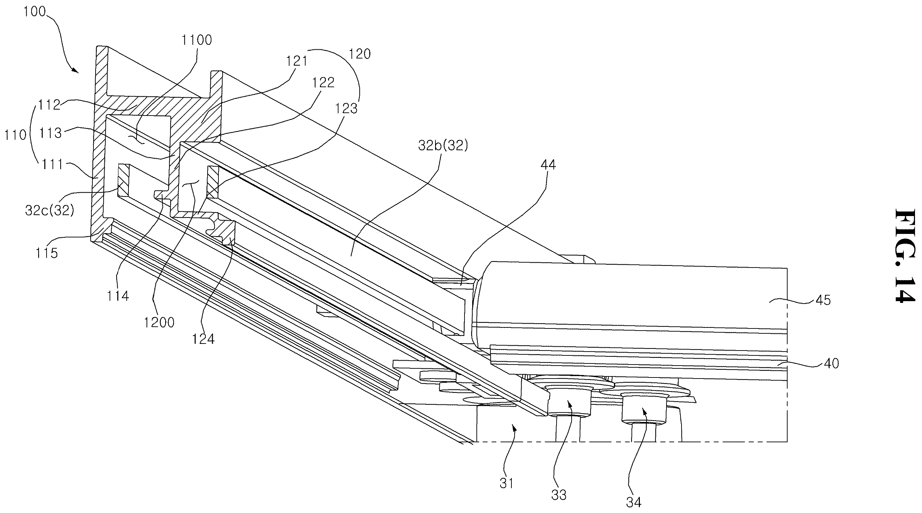

Referring to FIGs. 13 and 14, a light-shielding film 45 may cover the front part 712 of the housing frame 71. The light-shielding film 45 may be coupled or fixed to the bar 40. The bar 40 may be located on the bar support 715. When the bar 40 is located on the bar support 715, the bar 40 may be located at a bottom dead point.

The display 10 may be located opposite the housing frame 71 with respect to the light-shielding film 45. The display 10 may face the light-shielding film 45 and/or the front part 712 of the housing frame 71. The bar 40 may be located adjacent to the rear surface of the display 10.

The belt 32 may be coupled or fixed to one end of the bar 40. A fixing assembly 43 and 44 may secure the belt 32 to one end of the bar 40. The fixing assembly 43 and 44 may include a fixing bracket 44 and a belt fixing member 43. The fixing bracket 44 may be fixed to one end of the bar 40. The belt 32 may be located between the fixing bracket 44 and the belt fixing member 43. The belt fixing member 43 may secure the belt 32 to the fixing bracket 44.

A middle frame 100 may be another embodiment of the above-described frame fixing member 16 (see FIG. 11). For example, the middle frame 100 may be a part in which the above-described side frame 20 (see FIG. 11) and the above-described frame fixing member 16 (see FIG. 11) are formed integrally as a single piece. In another example, the middle frame 100 may be another embodiment of the above-described side frame 20 (see FIG. 11).

The middle frame 100 may include an outer part 110 and an inner part 120. The outer part 110 may have a U-beam shape elongated to accommodate a belt 32c. The outer part 110 may include a first part 111, a second part 112, and a third part 113. The first part 111 may be an elongated plate. The first part 111 may define an outer surface of the middle frame 100. The second part 112 may extend perpendicularly from the first part 111 and may be connected to the third part 113. The third part 113 may face the first part 111 and may be connected to the second part 112. An inner guide rib 114 may protrude from the third part 113 to face the first part 111 and may be spaced apart from the first part 111. The belt 32c may be located in a space defined by the first part 111, the second part 112, and/or the third part 113. The belt 32c may be referred to as an outer belt 32c.

The inner part 120 may have a U-beam shape elongated to accommodate a belt 32b. The inner part 120 may include a first part 121, a second part 122, and a third part 123. The first part 121 may extend from the second part 112 of the outer part 110 and may form a plate together with the second part 112 of the outer part 110. The second part 122 may extend perpendicularly from the first part 121 and may form the same plate as the third part 113 of the outer part 110. The second part 122 may be integrally formed with the third part 113 of the outer part 110. The third part 123 may extend perpendicularly from the second part 122 and may face the first part 121. The belt 32b may be located in a space defined by the first part 121, the second part 122, and/or the third part 123. The belt 32b may be referred to as an inner belt 32b.

The belt 32c located on the outer part 110 may be located opposite the belt 32b located on the inner part 120 with respect to the third part 113 of the outer part 110 and/or the second part 122 of the inner part 120. The fixing bracket 44 may be inserted into the inner part 120. The fixing bracket 44 may be located between the first part 121 and the third part 123 of the inner part 120.

A first coupling rib 115 may be formed on an inner surface of the first part 111 of the outer part 110. A second coupling rib 124 may be formed on an outer surface of the third part 123 of the inner part 120. The second coupling rib 124 may face the first coupling rib 115.

Referring to FIGs. 15 and 16, the fixing assembly 43 and 44 may be inserted between the first part 121 and the third part 123 of the inner part 120 of the middle frame 100. A bracket base 440 of the fixing bracket 44 may be fixed to one end of the bar 40. An insert tip 449 (see FIG. 17) and alignment tips 447 and 448 (see FIG. 17) of the bracket base 440 may be inserted into one end surface of the bar 40.

A first side wall 441 of the fixing bracket 44 may be supported by the third part 123 of the inner part 120 of the middle frame 100. A first support rib 442 formed on the first side wall 441 of the fixing bracket 44 may be in contact with or slide along the third part 123 of the inner part 120.

A second side wall 444 of the fixing bracket 44 may be supported by the first part 121 of the inner part 120 of the middle frame 100. A second support rib 445 formed on the second side wall 444 of the fixing bracket 44 may be in contact with or slide along the first part 121 of the inner part 120.

The first side wall 441 and/or the second side wall 444 may be supported by or spaced apart from the second part 122 of the inner part 120 of the middle frame 100. The first side wall 441 and/or the third side wall 443 may be supported by or spaced apart from the second part 122 of the inner part 120 of the middle frame 100. A gap may be defined between the side walls 441, 443, and 444 and the second part 122 of the inner part 120 of the middle frame 100. A lubricant may be applied between the fixing bracket 44 and the inner part 120 of the middle frame 100.

The frame cover 130 may be coupled to the first coupling rib 115 of the outer part 110 and/or to the second coupling rib 124 of the inner part 120. The frame cover 130 may define one surface of the middle frame 100.

Accordingly, both ends of the bar 40 may be maintained at the same horizontal level, and noise and/or vibration that may occur between the bar 40 and the middle frame 100 may be reduced.

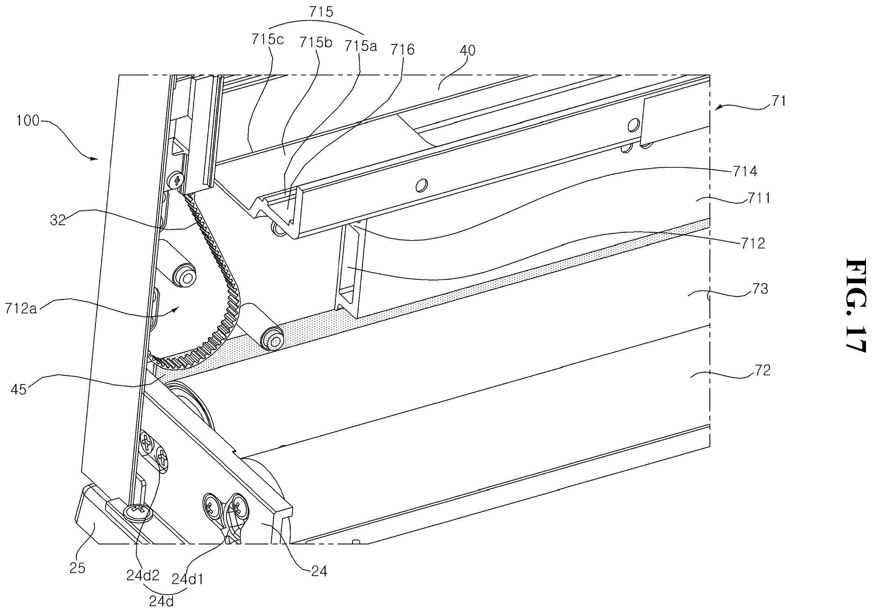

Referring to FIG. 17, the middle frame 100 may be coupled to the base frame 25. A roller bracket 24 may be coupled to the base frame 25 and/or to the middle frame 100. The roller bracket 24 may include a roller mount 24d. The roller mount 24d may be provided in plural. For example, a main roller mount 24d1 and a sub-roller mount 24d2 may be formed on the roller bracket 24. The sub-roller mount 24d2 may be adjacent to the main roller mount 24d1. The sub-roller mount 24d2 may be located between the main roller mount 24d1 and the housing frame 71.

A main roller 72 may be rotatably coupled to the main roller mount 24d1. The light-shielding film 45 may be wound around the main roller 72. The light-shielding film 45 wound around the main roller 72 may be unwound from or wound onto the main roller 72. A sub-roller 73 may support the light-shielding film 45. As the light-shielding film 45 is unwound from the main roller 72, the sub-roller 73 may guide the light-shielding film 45 toward the front surface of the housing frame 71.

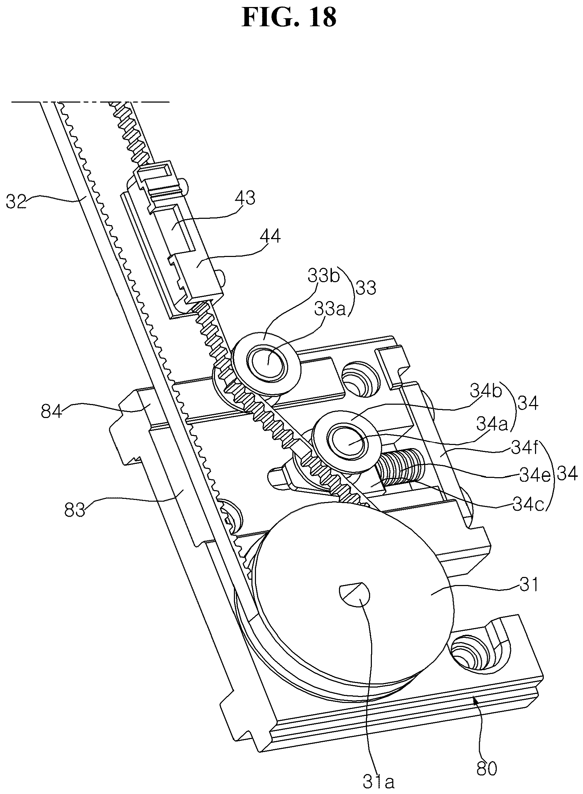

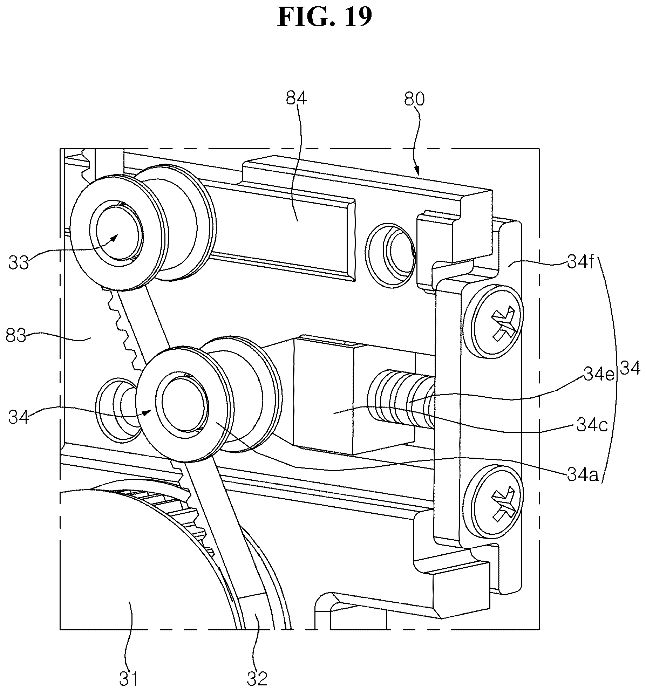

Referring to FIGs. 18 and 19, both ends of the belt 32 may be connected to each other by the fixing assembly 43 and 44. The fixing assembly 43 and 44 may secure the belt 32 to one end of the bar 40 (see FIG. 17). The belt 32 may be wound around a driving pulley 31. For example, the belt 32 may be a timing belt. The inner teeth of the belt 32 may be engaged with the teeth on the outer circumferential surface of the driving pulley 31. The outer surface of the belt 32 may be a smooth surface. A sub-pulley 33 may support the outer surface of the belt 32. A rotation shaft 33a of the sub-pulley 33 may be parallel to a rotation shaft 31a of the driving pulley 31. For example, a line interconnecting the rotational center of the sub-pulley 33 and the rotational center of the driving pulley 31 may be parallel to the upward-downward direction of the belt 32. The driving pulley 31 may have a larger diameter than a pulley 33b of the sub-pulley 33. Between the sub-pulley 33 and the driving pulley 31, a portion of the belt 32 may form an incline relative to an opposite portion of the belt 32.

A pulley 34b of a tension pulley 34 may be located between the sub-pulley 33 and the driving pulley 31. The pulley 34b of the tension pulley 34 may support the outer surface of the belt 32. The pulley 34b of the tension pulley 34 may push the outer surface of the belt 32. The tension of the belt 32 may be automatically adjusted by the force with which the pulley 34b of the tension pulley 34 pushes the outer surface of the belt 32. Accordingly, the tension of the belt 32 may be maintained at a constant level.

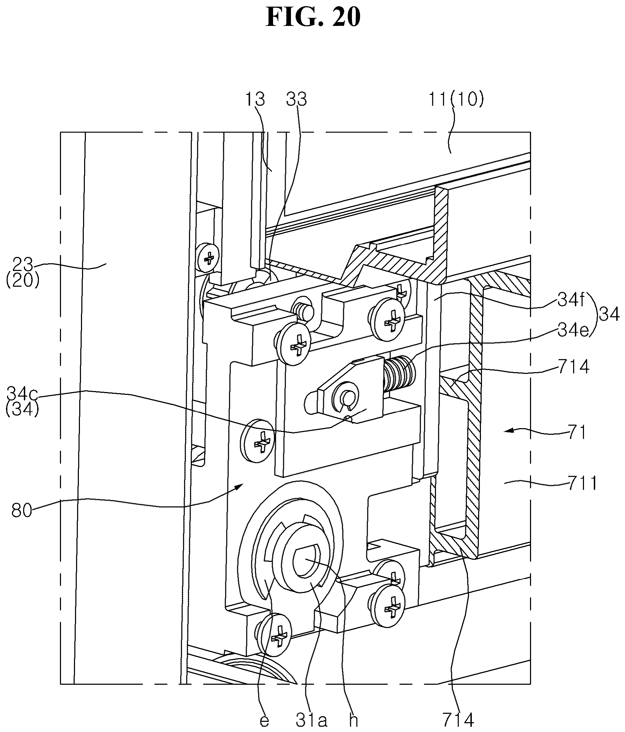

Referring to FIG. 20, a pulley block 80 may be coupled to the rear side of the housing frame 71. The pulley block 80 may be fixed to the rear surface of the housing frame 71. The pulley block 80 may be fixed to the mounting part 712a (see FIG. 17) of the housing frame 71.

The rotation shaft 31a of the driving pulley 31 (see FIG. 19) may be exposed from the rear surface of the pulley block 80 fixed to the mounting part 712a (see FIG. 17) of the housing frame 71. An E-ring e may be coupled to the rotation shaft 31a of the driving pulley 31. A power hole h may be formed in the rotation shaft 31a of the driving pulley 31.

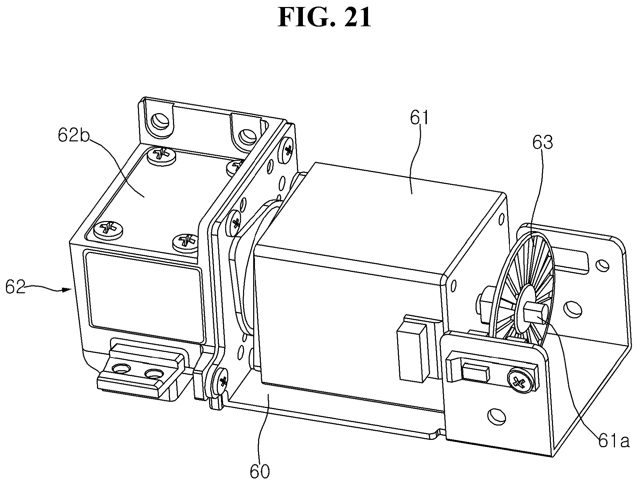

Referring to FIG. 21, a gearbox 62 may be located adjacent to the motor 61 and may be coupled to the motor 61. A motor bracket 60 may be fixed to the gearbox 62. The motor 61 may be located on the motor bracket 60 and may be fixed to the motor bracket 60. The motor 61 may be connected to the gearbox 62. A rotation counter 63 may be fixed to one end of a motor shaft 61a so as to rotate together with the motor shaft 61a. The gearbox 62 may be connected to the other end of the motor shaft 61a. The gearbox 62 may transmit rotational power provided from the motor 61 to the rotation shaft 31a (see FIG. 18) of the driving pulley 31 (see FIG. 18).

The gearbox 62 may have a rectangular box shape with one surface open. A box cover 62b may cover an opening defined by the open surface of the gearbox 62. The box cover 62b may be fixed to the opening of the gearbox 62.

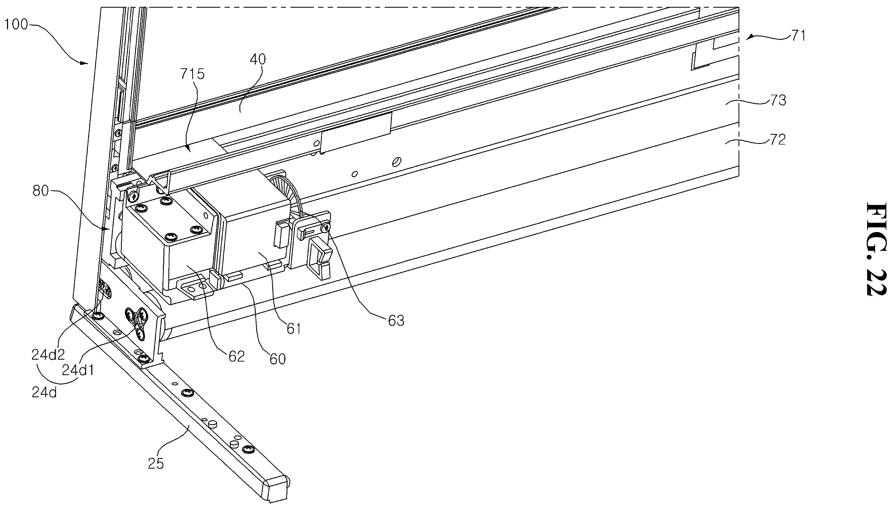

Referring to FIG. 22, when rotational power is provided from the motor 61, the driving pulley 31 (see FIG. 18) may rotate through the gearbox 62. When the driving pulley 31 rotates, the belt 32 (see FIG. 18) may move, and the bar 40 fixed to the belt 32 (see FIG. 18) by the fixing assembly 43 and 44 (see FIG. 18) may move upward and downward along the middle frame 100.

When the bar 40 moves upward along the middle frame 100, the light-shielding film 45 (see FIG. 17) having one end fixed to the bar 40 may move together with the bar 40. When the bar 40 moves, the light-shielding film 45 (see FIG. 17) wound around the main roller 72 may be unwound, and the light-shielding film 45 (see FIG. 17) may move upward along the middle frame 100.

When the bar 40 moves downward along the middle frame 100, the main roller 72 may wind the light-shielding film 45 (see FIG. 17). As the light-shielding film 45 is wound onto the main roller 72, the light-shielding film 45 (see FIG. 17) may move downward along the middle frame 100.

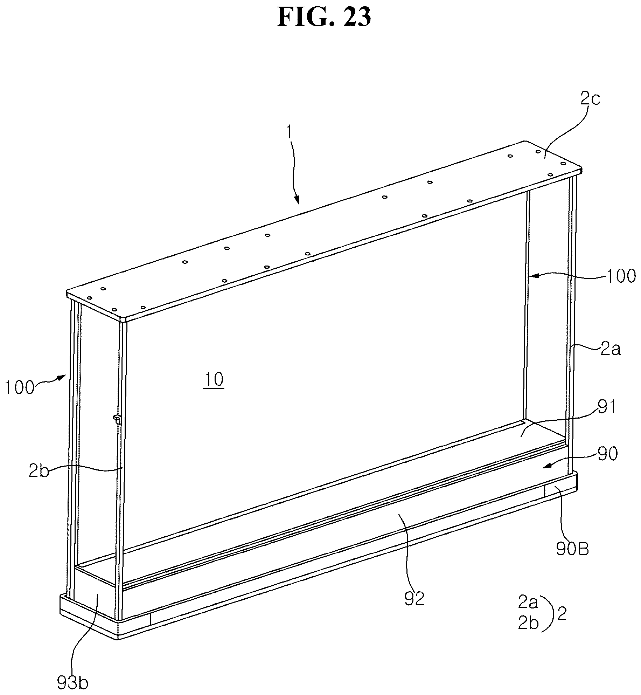

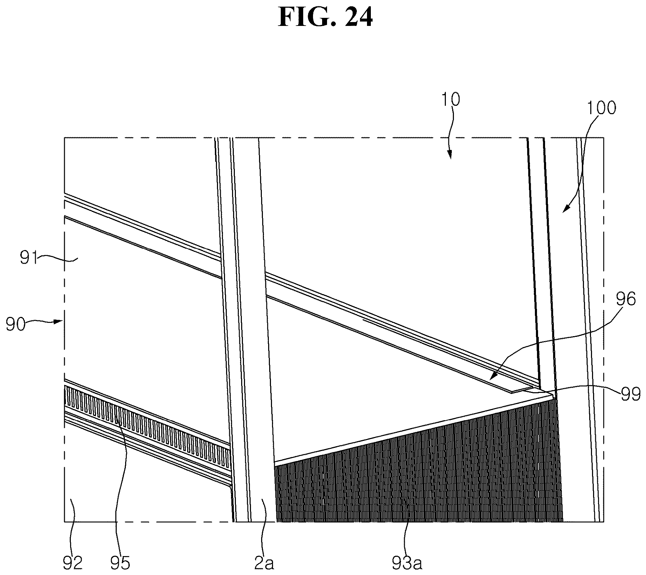

Referring to FIGs. 23 and 24, the display device 1 may include a middle frame 100, rear frames 2a and 2b, a top roof 2c, a housing 90, and a bottom base 90B. The bottom base 90B may be located at a lower portion of the display device 1 and may define a bottom of the display device 1. The housing 90 may be located on the bottom base 90B. The middle frame 100 may be coupled or fixed to the bottom base 90B. The top roof 2c may be coupled or fixed to an upper end of the middle frame 100.

The first rear frame 2a may be located parallel to the middle frame 100 and may be coupled to the top roof 2c and the housing 90. The second rear frame 2b may be located parallel to the middle frame 100 and may be coupled to the top roof 2c and the housing 90.

The housing 90 may be a rectangular box elongated along the second long side LS2 (see FIG. 1) of the display 10. The housing 90 may include a top plate 91, a rear plate 92, and side plates 93b. The top plate 91 may be a plate that is located at a rear side of the display 10 and is disposed in the thickness direction of the display 10. A door opening 99 may be formed between the top plate 91 and the display 10. A door cover 96 may open and close the door opening 99.

The housing 90 may further include a heat-dissipation grill 95 in which a plurality of slits (not denoted by a reference numeral) is defined. The heat-dissipation grill 95 may be provided on the rear surface of the housing 90. The heat-dissipation grill 95 may be elongated along a lower side of the display 10, and the slits may be arranged in the longitudinal direction of the heat-dissipation grill 95. The heat-dissipation grill 95 may be disposed on the rear plate 92. The heat-dissipation grill 95 may be disposed between the rear plate 92 and the top plate 91. The heat-dissipation grill 95 may be coupled between the pair of rear frames 2a and 2b. For example, the heat-dissipation grill 95 may be provided on the rear surface of the housing 90 to allow communication between the outside and the inside of the housing 90. With this configuration, heat generated from electric components in the housing 90 may be dissipated to the outside through the heat-dissipation grill 95.

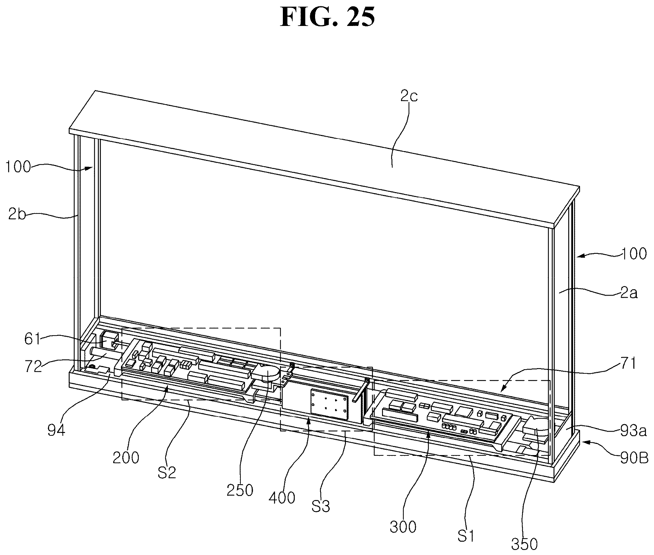

Referring to FIG. 25, the display device 1 may include at least one board assembly and at least one blower, which are provided in the housing 90. In one embodiment, the board assembly may be provided in a modular form including at least one board and a bracket configured to fix the at least one board inside the housing 90.

The board assembly may be electrically connected to the display 10. For example, the board assembly may be mounted in the housing 90 and electrically connected to the display 10 to transmit signals or supply power to the display 10.

The at least one board assembly may include a first board assembly 300, a second board assembly 200, and a third board assembly 400. The first to third board assemblies 300, 200, and 400 may be located above the main roller 72. The first to third board assemblies 300, 200, and 400 may be arranged in the longitudinal direction of the main roller 72. The first to third board assemblies 300, 200, and 400 may be arranged in a line.

The first board assembly 300 and the second board assembly 200 may be spaced apart from each other. The third board assembly 400 may be provided between the first board assembly 300 and the second board assembly 200.

The at least one blower may include a first blower 350 and a second blower 250. The at least one blower may generate airflow within the housing 90. For example, the first and second blowers 350 and 250 may generate airflow within the housing 90 in the direction in which the first to third board assemblies 300, 200, and 400 are arranged.

The first and second blowers 350 and 250 may be spaced apart from each other within the housing 90. The first blower 350 may be provided adjacent to the first board assembly 300. The first board assembly 300 may be provided between the first blower 350 and the third board assembly 400. For example, the first blower 350, the first board assembly 300, and the third board assembly 400 may be sequentially arranged in a line.

The first blower 350 may generate airflow toward the first board assembly 300. The first blower 350 may also generate airflow toward the third board assembly 400. For example, the airflow generated by the first blower 350 may flow over the first board assembly 300 and then over the third board assembly 400.

The second blower 250 may be provided adjacent to the second board assembly 200. The second blower 250 may generate airflow toward the second board assembly 200. The second blower 250 may be provided between the second board assembly 200 and the third board assembly 400. The flow direction of the airflow generated by the second blower 250 may correspond to the flow direction of the airflow generated by the first blower 350.

Accordingly, airflow within the housing 90 may flow smoothly.

In addition, air may smoothly circulate between the outside and the inside of the housing 90.

Referring to FIGs. 25 to 27, the first board assembly 300 may be provided in the housing 90. The first board assembly 300 may be referred to as a first horizontal board assembly 300. The first board assembly 300 may include at least one first board 310 and a first mounting bracket 330 configured to fix the at least one first board 310 inside the housing 90. The at least one first board 310 may be mounted on the first mounting bracket 330, and the first mounting bracket 330 may be mounted in the housing 90.

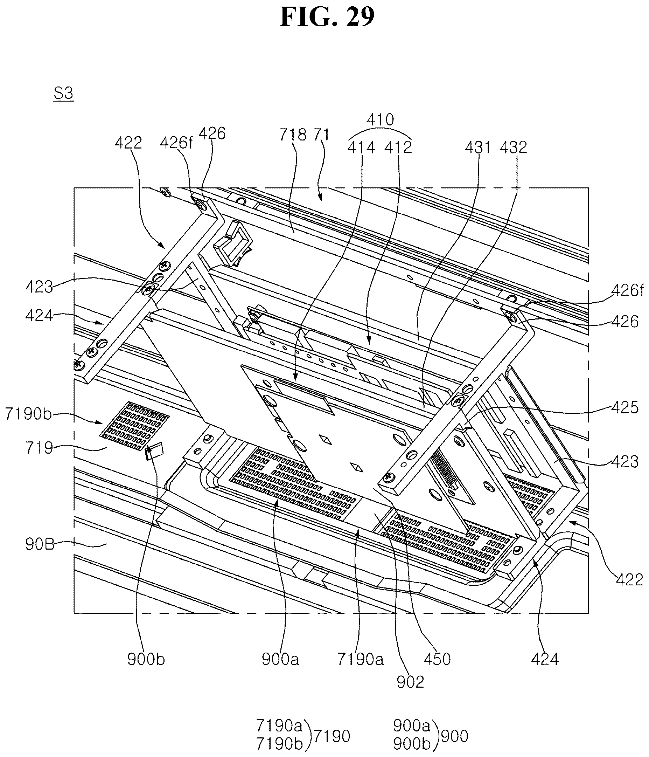

The at least one first board 310 may be disposed parallel to the bottom surface of the housing 90. The at least one first board 310 may be disposed parallel to the bottom surface 719 (see FIG. 29) of the housing frame 71. The at least one first board 310 may include a surface on which chips are mounted, and the surface of the at least one first board 310 may form an angle with the front or rear surface of the display panel 11. The surface of the at least one first board 310 may face upward. For example, the at least one first board 310 may be horizontally disposed such that the upper surface thereof faces upward, and the upper surface of the at least one first board 310 may form an approximately 90-degree angle with the front surface of the display 10.

The first board 310 may include an upper board 312 and a lower board 314. The upper board 312 may be provided over the lower board 314. The lower board 314 may be provided under the upper board 312. The upper board 312 and the lower board 314 may be disposed parallel to each other. The upper board 312 may cover the lower board 314. The upper board 312 may have a larger area than the lower board 314. The upper board 312 may include a surface on which chips are mounted, and the surface of the upper board 312 may face upward. The lower board 314 may include a surface on which chips are mounted, and the surface of the lower board 314 may face upward. The surface of the lower board 314 may face the upper board 312. The lower board 314 may be provided between the upper board 312 and the bottom surface of the housing 90.

The upper board 312 may include a first power supply (not denoted by a reference numeral) configured to supply power. For example, the upper board 312 may supply power to the display 10, the motor, a speaker, or other boards.

The lower board 314 may include an amplifier (not denoted by a reference numeral) configured to amplify media signals. For example, the lower board 314 may receive and amplify audio signals and/or video signals, and may transmit the amplified signals to the display 10 and/or to the speaker.

The first mounting bracket 330 may include an upper mount 320 configured to fix the upper board 312 inside the housing 90. The upper board 312 may be mounted on the upper mount 320. The upper mount 320 may include an upper mounting plate 322 on which the upper board 312 is seated. The upper mounting plate 322 may include a horizontal seating surface (not denoted by a reference numeral) to which the upper board 312 is coupled. For example, the upper board 312 may be horizontally disposed on the upper mounting plate 322 of the upper mount 320 and may be fastened to the upper mounting plate 322.

The upper mount 320 may further include flange portions 324 and 326 configured to be coupled to the housing 90. The flange portions 324 and 326 may be bent and extend from the upper mounting plate 322. For example, the flange portions 324 and 326 may be bent and extend vertically from the upper mounting plate 322 that is disposed horizontally.

The flange portions 324 and 326 of the upper mount 320 may include a first flange portion 324 extending from one end of the upper mounting plate 322 and a second flange portion 326 extending from the other end of the upper mounting plate 322. The first flange portion 324 and the second flange portion 326 may be opposite each other with respect to the upper mounting plate 322. For example, the first flange portion 324 may be bent upward and extend vertically from the front end of the upper mounting plate 322, and the second flange portion 326 may be bent downward and extend vertically from the rear end of the upper mounting plate 322.

The first board assembly 300 may be coupled to the housing frame 71. The housing frame 71 may include a front wall 718 to which the first board assembly 300 is coupled. The front wall 718 may be bent and extend upward from the bottom surface 719 (see FIG. 29) of the housing frame 71. The front wall 718 may be provided between the first board assembly 300 and the display 10.

The first flange portion 324 of the upper mount 320 may include a first upper flange 325 coupled to the front wall 718 of the housing frame 71. The first upper flange 325 may extend parallel to the front or rear surface of the display 10. For example, the first upper flange 325 may extend vertically to be disposed on the rear surface of the front wall 718. The first upper flange 325 and the front wall 718 may be fastened to each other using a fastening member (not shown). The fastening member (not shown) may be fastened forward through the first upper flange 325 and the front wall 718. Accordingly, the upper mount 320 may be fixed to the front wall 718.

The housing 90 may further include a housing bracket 94 to which the first board assembly 300 is coupled. The housing bracket 94 may be provided between the pair of rear frames 2a and 2b. The housing bracket 94 may be elongated in the longitudinal direction of the lower side of the display 10. The rear plate 92 (see FIG. 24) of the housing 90 may be coupled to the housing bracket 94. The housing bracket 94 may protrude upward from the rear end of the bottom base 90B. For example, the housing bracket 94 may extend vertically.

The second flange portion 326 of the upper mount 320 may include a second upper flange 327 coupled to the housing bracket 94. The second upper flange 327 may extend parallel to the front or rear surface of the display 10. The second upper flange 327 may be parallel to the first upper flange 325. For example, the second upper flange 327 may extend vertically to be disposed on the rear surface of the housing bracket 94. The second upper flange 327 and the housing bracket 94 may be fastened to each other using a fastening member 326f. The fastening member 326f may be fastened forward through the second upper flange 327 and the housing bracket 94. Accordingly, the upper mount 320 may be fixed to the housing bracket 94.

Accordingly, an operator may easily couple the upper mount 320 and the housing 90 from the rear side of the display device 1 using the fastening members. For example, the operator may easily fasten the upper mount 320 and the housing 90 while the display panel 11 is laid on a work table.

In addition, the display device 1 having improved assemblability may be provided.

The first mounting bracket 330 may include a lower mount 340 configured to fix the lower board 314 inside the housing 90. The lower mount 340 may be provided below the upper mount 320. The upper mount 320 may cover the lower mount 340. The upper mount 320 may have a larger size than the lower mount 340. For example, the lower mount 340 and the upper mount 320 may form a stacked structure.

The lower board 314 may be mounted on the lower mount 340. The lower mount 340 may include a lower mounting plate 342 on which the lower board 314 is seated. The lower mounting plate 342 may include a horizontal seating surface (not denoted by a reference numeral) to which the board is coupled. For example, the lower board 314 may be horizontally disposed on the lower mounting plate 342 of the lower mount 340 and may be fastened to the lower mounting plate 342.

The lower mount 340 may further include flange portions 344 and 346 configured to be coupled to the housing 90. The flange portions 344 and 346 may be bent and extend from the lower mounting plate 342. For example, the flange portions 344 and 346 may be bent and extend vertically from the lower mounting plate 342 that is disposed horizontally.

The flange portions 344 and 346 of the lower mount 340 may include a first flange portion 344 extending from one end of the lower mounting plate 342 and a second flange portion 346 extending from the other end of the lower mounting plate 342. The first flange portion 344 and the second flange portion 346 may be opposite each other with respect to the lower mounting plate 342. For example, the first flange portion 344 may be bent upward and extend vertically from the front end of the lower mounting plate 342, and the second flange portion 346 may be bent downward and extend vertically from the rear end of the lower mounting plate 342.

The first flange portion 344 of the lower mount 340 may include a first lower flange 345 coupled to the front wall 718 of the housing frame 71. The first lower flange 345 may extend parallel to the front or rear surface of the display 10. For example, the first lower flange 345 may extend vertically to be disposed on the rear surface of the front wall 718. The first lower flange 345 and the front wall 718 may be fastened to each other using a fastening member (not shown). The fastening member (not shown) may be fastened forward through the first lower flange 345 and the front wall 718. Accordingly, the lower mount 340 may be fixed to the front wall 718.

The second flange portion 346 of the lower mount 340 may include a second lower flange 347 coupled to the housing bracket 94. The second lower flange 347 may extend parallel to the front or rear surface of the display 10. The second lower flange 347 may be parallel to the first lower flange 345. For example, the second lower flange 347 may be disposed on the rear surface of the housing bracket 94. The second lower flange 347 and the housing bracket 94 may be fastened to each other using a fastening member 346f. The fastening member 346f may be fastened forward through the second lower flange 347 and the housing bracket 94. Accordingly, the lower mount 340 may be fixed to the housing bracket 94.

Accordingly, the operator may easily couple the lower mount 340 and the housing 90 from the rear side of the display device 1 using the fastening members. For example, the operator may easily fasten the lower mount 340 and the housing 90 while the display panel 11 is laid on the work table.

In addition, the display device 1 having improved assemblability may be provided.

The first blower 350 may generate a first airflow AF1 toward the first board assembly 300. The first blower 350 may be located above the first board assembly 300. The first airflow AF1 may flow over the first board assembly 300. For example, the first blower 350 may be located above one surface of the upper board 312, and the first airflow AF1 generated by the first blower 350 may flow over the surface of the upper board 312 to absorb heat generated from the upper board 312.

Accordingly, the first blower 350 may generate airflow within the housing 90, and heat emitted from the first board assembly 300 may be rapidly dissipated. As a result, the performance of the first board assembly 300 and the performance of the display device 1 may be improved.

In addition, the display device 1 having improved heat dissipation performance may be provided.

The first airflow AF1 may flow over the first board assembly 300, and may then flow toward the third board assembly 400. The amount of heat generated from the third board assembly 400 may be greater than that generated from the first board assembly 300. Accordingly, the first airflow may flow from the first board assembly 300 toward the third board assembly 400 and may further absorb heat generated from the third board assembly 400.

As a result, the first blower 350 may also rapidly dissipate the heat emitted from the third board assembly 400. This may improve the performance of the third board assembly 400 and the performance of the display device 1.

In addition, the display device 1 having improved heat dissipation performance may be provided.

The display device 1 may further include a first blower bracket 360 on which the first blower 350 is mounted. The first blower bracket 360 may be provided in the housing 90. The first blower bracket 360 may be disposed above the upper mount 320. The first blower 350 may be disposed above the upper board 312.

The first blower bracket 360 may include a first tray 362 on which the first blower 350 is mounted and extension portions 364 and 366 coupled to the housing 90. The first tray 362 may be parallel to the upper mounting plate 322 or the lower mounting plate 342. For example, the first blower 350 may be disposed on the first tray 362 that is disposed horizontally.

The extension portions 364 and 366 may include a first extension portion 364 extending from the first tray 362 toward the front wall 718 and a second extension portion 366 extending from the first tray 362 toward the side plate 93a of the housing 90. The first extension portion 364 may be bent and extend from one end of the first tray 362. The second extension portion 366 may be bent and extend from the other end of the first tray 362. For example, the first extension portion 364 may be bent upward and extend from the front end of the horizontal first tray 362. For example, the second extension portion 366 may be bent upward and extend from the side end of the horizontal first tray 362.

The first extension portion 364 may include a first extension flange 365 coupled to the front wall 718 of the housing frame 71. The first extension flange 365 may extend parallel to the front or rear surface of the display 10. For example, the first extension flange 365 may extend vertically to be disposed on the rear surface of the front wall 718. The first extension portion 364 and the front wall 718 may be fastened to each other using a fastening member (not shown). The fastening member (not shown) may be fastened forward through the first extension flange 365 and the front wall 718. Accordingly, the first blower bracket 360 may be fixed to the front wall 718.

The second extension portion 366 may be supported by the roller bracket 24. The second extension portion 366 may be supported by an upper end of the roller bracket 24. The second extension portion 366 may include a second extension flange 367 coupled to the housing 90. The second extension flange 367 may extend parallel to the side plate 93a of the housing 90. For example, the second extension flange 367 may extend vertically.

Accordingly, the operator may easily couple the first blower bracket 360 and the housing 90 from the rear side of the display device 1 using the fastening member. For example, the operator may easily fasten the first blower bracket 360 and the housing 90 while the display panel 11 is laid on the work table.

In addition, the display device 1 having improved assemblability may be provided.

Referring to FIGs. 25, 26, and 28, the second board assembly 200 may be provided in the housing 90. The second board assembly 200 may be referred to as a second horizontal board assembly 200. The second board assembly 200 may include a second board 210 and a second mounting bracket 220 configured to fix the second board 210 inside the housing 90. The second board 210 may be mounted on the second mounting bracket 220, and the second mounting bracket 220 may be mounted in the housing 90.

The second board 210 may be disposed parallel to the bottom surface of the housing 90. The second board 210 may be disposed parallel to the first board 310. The second board 210 may be disposed parallel to the bottom surface 719 (see FIG. 29) of the housing frame 71. The second board 210 may include a surface on which chips are mounted, and the surface of the second board 210 may form an angle with the front or rear surface of the display 10. The surface of the second board 210 may face upward. For example, the second board 210 may be horizontally disposed, and the upper surface of the second board 210 may form an approximately 90-degree angle with the front surface of the display 10.

The second board 210 may include a second power supply (not denoted by a reference numeral) configured to supply power. For example, the second board 210 may supply power to the display 10, the motor, the speaker, or other boards.

The second mounting bracket 220 may fix the second board 210 inside the housing 90. The second board 210 may be mounted on the second mounting bracket 220. The second mounting bracket 220 may include a mounting plate 222 on which the second board 210 is seated. The mounting plate 222 may include a horizontal seating surface (not denoted by a reference numeral) to which the second board 210 is coupled. For example, the second board 210 may be horizontally disposed on the mounting plate 222 of the second mounting bracket 220 and may be fastened to the mounting plate 222.

The second mounting bracket 220 may further include flange portions 224 and 226 configured to be coupled to the housing 90. The flange portions 224 and 226 may be bent and extend from the mounting plate 222. For example, the flange portions 224 and 226 may be bent and extend vertically from the mounting plate 222 that is disposed horizontally.

The flange portions 224 and 226 of the second mounting bracket 220 may include a first flange portion 224 extending from one end of the mounting plate 222 and a second flange portion 226 extending from the other end of the mounting plate 222. The first flange portion 224 and the second flange portion 226 may be opposite each other with respect to the mounting plate 222. For example, the first flange portion 224 may be bent upward and extend vertically from the front end of the mounting plate 222, and the second flange portion 226 may be bent downward and extend vertically from the rear end of the mounting plate 222.

The first flange portion 224 of the second mounting bracket 220 may include a first flange plate 225 coupled to the front wall 718 of the housing frame 71. The first flange plate 225 may extend parallel to the front or rear surface of the display 10. For example, the first flange plate 225 may extend vertically to be disposed on the rear surface of the front wall 718. The first flange plate 225 and the front wall 718 may be fastened to each other using a fastening member 224f. The fastening member 224f may be fastened forward through the first flange plate 225 and the front wall 718. Accordingly, the second mounting bracket 220 may be fixed to the front wall 718.

The second flange portion 226 of the second mounting bracket 220 may include a second flange plate 227 coupled to the housing bracket 94. The second flange plate 227 may extend parallel to the front or rear surface of the display 10. The second flange plate 227 may be parallel to the first flange plate 225. For example, the second flange plate 227 may extend vertically to be disposed on the rear surface of the housing bracket 94. The second flange plate 227 and the housing bracket 94 may be fastened to each other using a fastening member 226f. The fastening member 226f may be fastened forward through the second flange plate 227 and the housing bracket 94. Accordingly, the second mounting bracket 220 may be fixed to the housing bracket 94.

Accordingly, the operator may easily couple the second mounting bracket 220 and the housing 90 from the rear side of the display device 1 using the fastening members 224f and 226f. For example, the operator may easily fasten the second mounting bracket 220 and the housing 90 while the display panel 11 is laid on the work table.

In addition, the display device 1 having improved assemblability may be provided.

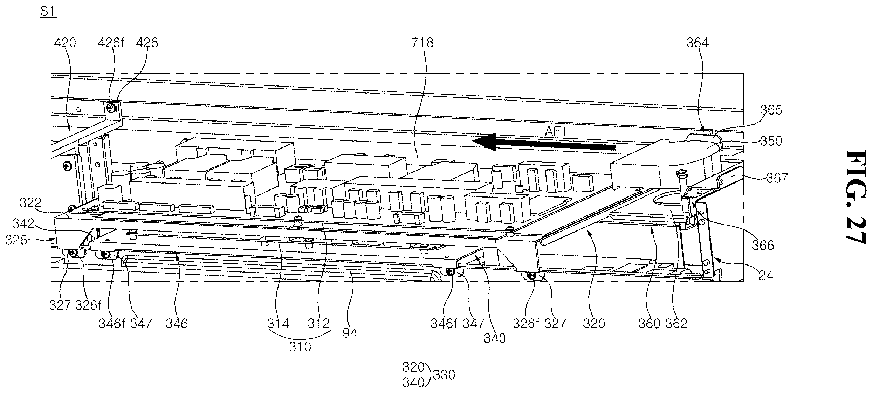

The second blower 250 may generate a second airflow AF2 toward the second board assembly 200. The flow direction of the second airflow AF2 may be parallel to the flow direction of the first airflow AF1 (see FIG. 27). The second blower 250 may be located above the second board assembly 200. The second airflow AF2 may flow over the second board assembly 200. For example, the second blower 250 may be located above one surface of the second board 210, and the second airflow AF2 generated by the second blower 250 may flow over the surface of the second board 210 to absorb heat generated from the second board 210.

Accordingly, the second blower 250 may generate airflow within the housing 90, and heat emitted from the second board assembly 200 may be rapidly dissipated. As a result, the performance of the second board assembly 200 and the performance of the display device 1 may be improved.

In addition, the display device 1 having improved heat dissipation performance may be provided.

The first airflow AF1 may sequentially flow over the first board assembly 300, the third board assembly 400, and the second board assembly 200. Accordingly, the first airflow may sequentially absorb heat generated from the first board assembly 300, the third board assembly 400, and the second board assembly 200.

As a result, the first blower 350 may also rapidly dissipate heat emitted from the second board assembly 200. This may improve the performance of the second board assembly 200 and the performance of the display device 1.

In addition, the display device 1 having improved heat dissipation performance may be provided.

The display device 1 may further include a second blower bracket 260 on which the second blower 250 is mounted. The second blower bracket 260 may be provided in the housing 90. The second blower bracket 260 may be disposed above the second mounting bracket 220. The second blower 250 may be disposed above the second board 210.

The second blower bracket 260 may include a second tray 262 on which the second blower 250 is mounted and extension portions 264 and 266 extending from the second tray 262. The second tray 262 may be parallel to the mounting plate 222 of the second mounting bracket 220. For example, the second blower 250 may be disposed on the second tray 262 that is disposed horizontally.

The extension portions 264 and 266 may include a first extension portion 264 extending from the second tray 262 toward the front wall 718 and a second extension portion 266 extending from the second tray 262 toward the third board assembly 400. The first extension portion 264 may be bent and extend from one end of the second tray 262. The second extension portion 266 may be bent and extend from the other end of the second tray 262. For example, the first extension portion 264 may be bent upward and extend from the front end of the horizontal second tray 262. For example, the second extension portion 266 may be bent upward and extend from the side end of the horizontal second tray 262.

The first extension portion 264 may include a first extension flange 265 coupled to the front wall 718 of the housing frame 71. The first extension flange 265 may extend parallel to the front or rear surface of the display 10. For example, the first extension flange 265 may extend vertically to be disposed on the rear surface of the front wall 718. The first extension portion 264 and the front wall 718 may be fastened to each other using a fastening member 264f. The fastening member 264f may be fastened forward through the first extension flange 265 and the front wall 718. Accordingly, the second blower bracket 260 may be fixed to the front wall 718.

The second extension portion 266 may be coupled to the third board assembly 400. In detail, the second extension portion 266 may be coupled to a mounting frame 420 of the third board assembly 400. The mounting frame 420 may support the second extension portion 266.

Accordingly, the operator may easily couple the second blower bracket 260 and the housing 90 from the rear side of the display device 1 using the fastening member 264f. For example, the operator may easily fasten the second blower bracket 260 and the housing 90 while the display panel 11 is laid on the work table.

In addition, the display device 1 having improved assemblability may be provided.

Referring to FIGs. 25, 26, 29, and 30, the third board assembly 400 may be provided in the housing 90. The third board assembly 400 may be referred to as a vertical board assembly 400. The third board assembly 400 may include at least one third board 410 and a mounting frame 420 configured to fix the at least one third board 410 inside the housing 90. The at least one third board 410 may be fixed to the mounting frame 420, and the mounting frame 420 may be mounted in the housing 90.

The at least one third board 410 may be disposed parallel to the display 10. In detail, the at least one third board 410 may be disposed parallel to the front or rear surface of the display panel 11. The at least one third board 410 may include a surface on which chips are mounted, and the surface of the at least one third board 410 may be parallel to the front or rear surface of the display panel 11. The surface of the at least one third board 410 may face forward or backward. For example, the at least one third board 410 may be vertically disposed, and the surface of the at least one third board 410 may form an approximately 90-degree angle with the bottom surface of the housing 90.

The third board 410 may include a front board 412 and a rear board 414. The front board 412 may be provided in front of the rear board 414. The rear board 414 may be provided behind the front board 412. The front board 412 and the rear board 414 may be disposed parallel to each other. The front board 412 may include a surface on which chips are mounted, and the surface of the front board 412 may face forward or backward. The rear board 414 may include a surface on which chips are mounted, and the surface of the rear board 414 may face forward or backward. The surface of the front board 412 and the surface of the rear board 414 may be oriented in the same direction. That is, the surface of the front board 412 and the surface of the rear board 414 may not face each other.

The third board 410 may be referred to as a vertical board 410. The front board 412 may be referred to as a first vertical board, and the rear board 414 may be referred to as a second vertical board. Conversely, the front board 412 may be referred to as a second vertical board, and the rear board 414 may be referred to as a first vertical board.

The front board 412 may include a timing controller (not denoted by a reference numeral) configured to control timing of signals transmitted to the display panel 11. The timing controller (not denoted by a reference numeral) may be referred to as a T-CON board.

The rear board 414 may include a wireless device (not denoted by a reference numeral) configured to receive wireless signals. For example, the rear board 414 may include an antenna (not shown) and may receive at least one of a video signal, an audio signal, or broadcast program information via wireless communication.

The mounting frame 420 may include mounts 430 and 440 to which the third board 410 is mounted, mounting braces 423 and 425 to which the mounts 430 and 440 are coupled, and a fastening portion 426 coupled to the housing 90. The mounts may correspond to vertical plates on which the third board 410 is mounted. The mounts 430 and 440 may be disposed parallel to the front or rear surface of the display panel 11.

The mounting frame 420 may include a first mounting frame 422 to which the front board 412 is mounted and a second mounting frame 424 to which the rear board 414 is mounted. The first mounting frame 422 may be coupled to the front wall 718 of the housing frame 71, and the second mounting frame 424 may be coupled to the first mounting frame 422. The first mounting frame 422 and the second mounting frame 424 may alternatively be coupled to the bottom surface 719 (see FIG. 29) of the housing frame 71.

The mounts 430 and 440 may include a front mount 431 on which the front board 412 is mounted and a rear mount 432 on which the rear board 414 is mounted. The first mounting frame 422 may include the front mount 431, and the second mounting frame 424 may include the rear mount 432. The front mount 431 may be disposed in front of the rear mount 432. The rear mount 432 may be disposed behind the front mount 431. For example, the front mount 431 and the rear mount 432 may be vertically disposed and may be spaced apart from each other in the forward-backward direction. The front board 412 may be mounted on a rear surface of the front mount 431, and the rear board 414 may be mounted on a rear surface of the rear mount 432.

The mounts 430 and 440 may further include a cover plate 450 covering the rear board 414. The cover plate 450 may be disposed behind the rear mount 432. The cover plate 450 may have a smaller size than the rear mount 432. The cover plate 450 may protect the rear board 414 mounted on the rear surface of the rear mount 432.

The mounting braces 423 and 425 may be coupled to the mounts 430 and 440. Each of the mounting braces 423 and 425 may be coupled to one end of a corresponding one of the mounts 430 and 440. The mounting braces 423 and 425 may extend vertically, and the mounts 430 and 440 may be coupled to the vertical mounting braces 423 and 425.

The mounting braces 423 and 425 may include a first mounting brace 423 to which the front mount 431 is coupled and a second mounting brace 425 to which the rear mount 432 is coupled. The first mounting frame 422 may include the first mounting brace 423, and the second mounting frame 424 may include the second mounting brace 425. The first mounting brace 423 and the second mounting brace 425 may be parallel to each other.

The first mounting frame 422 may include a fastening portion 426. The fastening portion 426 may extend parallel to the third board 410. The fastening portion 426 may extend vertically. The fastening portion 426 may be coupled to the front wall 718 of the housing frame 71. For example, a fastening member 426f may be fastened forward through the fastening portion 426 and the front wall 718.

Accordingly, the operator may easily couple the third board assembly 400 and the housing 90 from the rear side of the display device 1 using the fastening member 426f. For example, the operator may easily fasten the third board assembly 400 and the housing 90 while the display panel 11 is laid on the work table.

In addition, the display device 1 having improved assemblability may be provided.

The housing 90 may include a plurality of vent holes 900 disposed under the third board assembly 400. The vent holes 900 and the front board 412 may overlap each other when viewed in plan. The vent holes 900 and the rear board 414 may overlap each other when viewed in plan. The vent holes 900 may allow communication between the outside and the inside of the housing 90. Outside air may enter the housing 90 through the vent holes 900, and inside air in the housing 90 may be discharged outside the housing 90 through the vent holes 900.

In one embodiment, the housing 90 may include a bottom base 90B. The housing frame 71 may have at least one opening 7190 defined in the bottom surface 719. The at least one opening 7190 may overlap the vent holes 900 when viewed in plan. The vent holes 900 may be defined in the bottom surface 902 of the bottom base 90B. When the bottom base 90B and the housing frame 71 are coupled, the vent holes 900 in the bottom base 90B may overlap the at least one opening 7190 in the housing frame 71 when viewed in plan. For example, first vent holes 900a defined in the bottom surface 902 of the bottom base 90B may overlap a first opening 7190a defined in the bottom surface 719 of the housing frame 71 when viewed in plan, and second vent holes 900b defined in the bottom surface 902 of the bottom base 90B may overlap a second opening 7190b defined in the bottom surface 719 of the housing frame 71 when viewed in plan.

Accordingly, air may be introduced through the vent holes 900 below the third board 410, and the introduced air may rise along the third board 410 disposed vertically. As a result, heat generated from the third board 410 may be smoothly dissipated.

In addition, because the blowers 250 and 350 generate airflows in one direction within the housing 90, heat generated from the third board assembly 400 may be smoothly dissipated.

In addition, because the wireless device or the timing controller, which generates a relatively large amount of heat, is vertically disposed above the vent holes, the performance of the wireless device or the timing controller may be improved.

Referring to FIGs. 1 to 30, a display device 1 may include a display panel 11 configured to display an image, a housing 90 elongated along a lower side of the display panel 11, and a vertical board assembly 400 provided in the housing 90 and electrically connected to the display panel 11. The vertical board assembly 400 may include a first vertical board 412 including chips mounted on a surface thereof disposed parallel to the display panel 11, and the housing 90 may include a plurality of vent holes 900 disposed under the first vertical board 412.

The vertical board assembly 400 may include a mounting frame 420 configured to fix the first vertical board 412 inside the housing 90.

The mounting frame 420 may include a mounting brace 423 configured to fix the first vertical board 412 and a fastening portion 426 coupled to the housing 90 and extending parallel to the surface of the first vertical board 412.

The vertical board assembly 400 may further include a second vertical board 414 disposed parallel to the first vertical board 412.

The first vertical board 412 may include a wireless device configured to receive a wireless signal.

The second vertical board 414 may include a timing controller configured to control the timing of a signal transmitted to the display panel 11.

The display device may further include a first board assembly 300 provided in the housing 90 and electrically connected to the display panel 11 and a first blower 350 provided in the housing 90 and configured to generate airflow toward the first board assembly 300.

The first board assembly 300 may be provided between the vertical board assembly 400 and the first blower 350.

The first board assembly 300 may include an upper board 312 including chips mounted on a surface thereof and an upper mount 320 configured to fix the upper board 312 inside the housing 90.

The surface of the upper board 312 may face upward.

The first blower 350 may be disposed above the surface of the upper board 312.

The upper mount 320 may include an upper flange 325 extending parallel to the surface of the first vertical board 412.

The first board assembly 300 may further include a lower board 314 provided under the upper board 312 and including chips mounted on a surface thereof and a lower mount 340 configured to fix the lower board 314 inside the housing 90.

The surface of the lower board 314 may face upward.

The lower mount 340 may include a lower flange 327 extending parallel to the surface of the first vertical board.

The display device may further include a second board assembly 200 provided in the housing 90 and electrically connected to the display panel 11.

The vertical board assembly 400 may be located between the first board assembly 300 and the second board assembly 200.

The second board assembly 200 may include a second board 210 including chips mounted on a surface thereof and a mounting bracket 220 configured to fix the second board 210 inside the housing 90.

The surface of the second board 210 may face upward.

The mounting bracket 220 may include flange plates 225 and 227 extending parallel to the surface of the first vertical board 412 and coupled to the housing 90.

The display device may further include a second blower 250 provided in the housing 90 and configured to generate airflow toward the second board assembly 200.

The second blower 250 may be provided between the second board assembly 200 and the vertical board assembly 400.

The upper board 312 may include a first power supply configured to supply power.

The lower board 314 may include an amplifier configured to amplify a media signal.

The second board 210 may include a second power supply configured to supply power.

As is apparent from the above description, the present disclosure has the following effects.

According to at least one of embodiments of the present disclosure, a display device having improved performance may be provided.

According to at least one of embodiments of the present disclosure, a display device having enhanced heat dissipation performance may be provided.

According to at least one of embodiments of the present disclosure, a heat dissipation structure capable of smoothly dissipating heat may be provided.

According to at least one of embodiments of the present disclosure, a display device having improved assemblability may be provided.

The additional scope of applicability of the present disclosure is apparent from the above detailed description. However, those skilled in the art will appreciate that various modifications and alterations are possible, without departing from the idea and scope of the present disclosure, and therefore it should be understood that the detailed description and specific embodiments, such as the preferred embodiments of the present disclosure, are provided only for illustration.

Certain embodiments or other embodiments of the disclosure described above are not mutually exclusive or distinct from each other. Any or all elements of the embodiments of the disclosure described above may be combined with each other in configuration or function.

For example, a configuration "A" described in one embodiment of the disclosure and/or the drawings and a configuration "B" described in another embodiment of the disclosure and/or the drawings may be combined with each other. Namely, although the combination between the configurations is not directly described, the combination is possible except in the case where it is described that the combination is impossible.

The above detailed description is not intended to be construed to limit the disclosure in all aspects and to be considered by way of example. The scope of the disclosure should be determined by reasonable interpretation of the appended claims and all equivalent modifications made without departing from the disclosure should be included in the following claims.

## Claims

1. A display device comprising:
a display panel configured to display an image;
a housing elongated along a lower side of the display panel; and
a vertical board assembly provided in the housing and electrically connected to the display panel,
wherein the vertical board assembly comprises a first vertical board having a surface on which chips are mounted, wherein the surface of the first vertical board is parallel to the display panel, and
wherein the housing comprises a plurality of vent holes under the first vertical board.

2. The display device according to claim 1, wherein the vertical board assembly comprises a mounting frame configured to fix the first vertical board inside the housing, and
wherein the mounting frame comprises:
a mounting brace configured to fix the first vertical board; and
a fastening portion coupled to the housing and extending parallel to the surface of the first vertical board.

3. The display device according to claim 1 or 2, wherein the vertical board assembly further comprises a second vertical board disposed parallel to the first vertical board,
wherein the first vertical board comprises a wireless device configured to receive a wireless signal, and
wherein the second vertical board comprises a timing controller configured to control timing of a signal transmitted to the display panel.

4. The display device according to any one of claims 1 to 3 , further comprising:
a first board assembly provided in the housing and electrically connected to the display panel; and
a first blower provided in the housing, the first blower being configured to generate airflow toward the first board assembly.

5. The display device according to claim 4, wherein the first board assembly is provided between the vertical board assembly and the first blower.

6. The display device according to claim 4 or 5, wherein the first board assembly comprises:
an upper board, wherein chips mounted on a surface thereof; and
an upper mount configured to fix the upper board inside the housing, and
wherein the surface of the upper board faces upward.

7. The display device according to claim 6, wherein the first blower is disposed above the surface of the upper board.

8. The display device according to claim 6 or 7, wherein the upper mount comprises an upper flange extending parallel to the surface of the first vertical board.

9. The display device according to any one of claims 6 to 8, wherein the first board assembly further comprises:
a lower board provided under the upper board, wherein chips mounted on a surface thereof; and
a lower mount configured to fix the lower board inside the housing, and
wherein the surface of the lower board faces upward.

10. The display device according to claim 9, wherein the lower mount comprises a lower flange extending parallel to the surface of the first vertical board.

11. The display device according to any one of claims 4 to 10, further comprising a second board assembly provided in the housing and electrically connected to the display panel,
wherein the vertical board assembly is located between the first board assembly and the second board assembly.

12. The display device according to claim 11, wherein the second board assembly comprises:
a second board, wherein chips mounted on a surface thereof; and
a mounting bracket configured to fix the second board inside the housing, and
wherein the surface of the second board faces upward.

13. The display device according to claim 12, wherein the mounting bracket comprises a flange plate extending parallel to the surface of the first vertical board and coupled to the housing.

14. The display device according to any one of claims 11 to 13, further comprising a second blower provided in the housing, the second blower being configured to generate airflow toward the second board assembly.

15. The display device according to claim 14, wherein the second blower is provided between the second board assembly and the vertical board assembly.
